Europäisches Patentamt

European Patent Office

Office européen des brevets

(11) Veröffentlichungsnummer: **0 423 651 A1**

## EUROPÄISCHE PATENTANMELDUNG

(21) Anmeldenummer: 90119630.3

(22) Anmeldetag: 12.10.90

(51) Int. Cl.5: **H05K 3/20**, H05K 3/04, G08B 13/24

(30) Priorität: 20.10.89 CH 3818/89

(43) Veröffentlichungstag der Anmeldung:
24.04.91 Patentblatt 91/17

(84) Benannte Vertragsstaaten:
DE FR GB IT

(71) Anmelder: **Pichl, Fritz, Dipl.-Ing.**
Seehalden Strasse 17
CH-8802 Kilchberg(CH)

(72) Erfinder: **Pichl, Fritz, Dipl.-Ing.**
Seehalden Strasse 17
CH-8802 Kilchberg(CH)

(74) Vertreter: **Büchel, Kurt F., Dr.**
Bergstrasse 297
FL-9495 Triesen(LI)

(54) Verfahren zur Herstellung einer Schaltungsanordnung, sowie Schaltungsanordnung auf einer Trägerfolie.

(57) Die Schaltungsanordnung weist wenigstens eine elektrische, geschnittene Leiterbahn (3) auf wenigstens einer Oberfläche einer Trägerfolie (2) auf, wobei die Trägerfolie (2) sowohl im Bereich der sie bedeckenden Leiterbahn (3) als auch ausserhalb davon frei von Deformationen und Schwankungen der Dicke ist. Die Kanten (4) der Leiterbahn weisen einen Vorsprung in Form eines Stanzbartes (6) auf.

Ein Schaltungsnegativ (15) wird auf einer leitenden Folie (9) mittels ein Klischee darstellender Stanzmesser (13) oder Prägestempel auf ein Stanzsubstrat (10) aufgebracht oder in dieses eingeprägt; die das verbleibende Schaltungspositiv (16) darstellende Leiterbahn (3) wird auf die Trägerfolie (2) transferiert.

Fig.2

**VERFAHREN ZUR HERSTELLUNG EINER SCHALTUNGSANORDNUNG, SOWIE SCHALTUNGSANORDNUNG AUF EINER TRÄGERFOLIE.**

Die Erfindung betrifft ein Verfahren zu Herstellung einer Schaltungsanordnung nach dem Oberbegriff des Anspruchs 1, sowie eine Schaltungsanordnung nach dem Oberbegriff des Anspruchs 6.

Derartige Schaltungsanordnungen werden für die unterschiedlichsten Zwecke gebraucht, z.B. auch für Resonanzetiketten. Solche Resonanzetiketten, die insbesondere bei der Warensicherung, z.B. in Kaufhäusern, eingesetzt werden, sollen aus aus naheliegenden Gründen möglichst einfach an allen möglichen Waren angebracht werden können und daher möglichst flach und flexibel ausgebildet sein, ohne dass ihre charakteristischen elektrischen Eigenschaften darunter leiden. Daher ist man bemüht, die Leiterbahnen auf einer möglichst dünnen Schicht aufzubringen, die sowohl als Träger- als auch als Isolationssubstrat dient. Die Leiterbahnen werden dabei in bekannter Weise entweder aus einer leitfähigen Folie herausgeätzt oder auf das Trägersubstrat aufgestanzt.

Photoätztechniken - so wie die auch teilweise angewandten Siebdrucktechniken - sind, vor allem im Hinblick auf die Komplexität des Fabrikationsprozesses, relativ aufwendig und - in ökologischer Hinsicht - nicht unbedenklich, fällt doch Ätzschlamm als nicht wieder aufbereitbares Wegwerfprodukt an. Eine mögliche Alternative dazu ist das Aufstanzen von Leiterbahnen auf ein Trägersubstrat. So wird in der US-PS-3678577 ein Verfahren beschrieben, bei dem die Leiterbahnen auf ein Trägersubstrat aufgestanzt werden, wobei ganz spezifische Eigenschaften für die verwendeten Substratmaterialien gefordert werden.

Nach einem herkömmlichen, der Heissprägetechnik entsprechenden Verfahren (in der EP-B1-0063347 erwähnt) werden Leiterbahnen auf ein Kunststoffsubstrat aufgebracht. Dabei wird eine Leiterfolie gemeinsam mit einer Trägerfolie auf ein Substrat aufgebracht und mittels eines geheizten Stempels auf das Substrat gepresst, wobei nur die Leiterbahnen abgeschert und gleichzeitig mit dem Substrat verklebt werden. Die Trägerfolie bleibt intakt und dient dazu, die nicht geprägten Teile der Leiterfolie abzuziehen. Es ist offensichtlich, dass beim Einprägen der Leiterbahn in das Substrat diese Trägerfolie keinesfalls mit abgeschert werden darf, da sonst entweder die Trägerfolie allein, oder nicht geprägte Leiterbahnteile, oder auch beide unvollständig entfernt werden. Da die Leiterbahnen bei diesem Verfahren etwas vertieft an der Oberfläche des Substrats zu liegen kommen, ist dieser Forderung nur mit ganz speziellen Trägerfolien-Materialien nachzukommen. Ausserdem muss das Substrat wenigstens doppelt so dick sein wie die Leiterschicht selbst, insbesondere dann, wenn auf der Rückseite des Substrats eine weitere Leiterbahnanordnung vorzusehen ist.

In dem in der EP-A1-292827 beschriebenen Verfahren zur Herstellung einer einen Schwingkreis tragenden Etikette werden die Leiterbahnen in zwei Schritten aus der Leiterfolie gestanzt. Dabei wird in einem ersten Schritt ein mittlerer Bahnbereich ausgestanzt und mit einem isolierenden Band abgedeckt. Die äusseren Bahnbereiche, die demnach nicht abgedeckt sind, werden in einem zweiten Schritt ausgestanzt. Dieses Laminat aus gestanzten und teilweise abgedeckten Leiterbahnen wird danach aus Stabilisierungsgründen auf eine Deckfolie aufgebracht. Problematisch dabei ist der zweifache Stanzvorgang, der überaus genau angesteuert sein muss, damit keine Unstetigkeitsstellen an den fertig gestanzten Leiterbahnen vorhanden sind. In gleicher Weise korrekt muss auch die Abdeckung des mittleren Bahnbereichs geschehen. Das isolierende Band soll ja einerseits nicht mitgestanzt werden, andererseits trotzdem aus Stabilisierungsgründen das gesamte mitt lere, bereits ausgestanzte Leiterband abdecken.

Die DE-A1-3732825 beschreibt ebenfalls ein Verfahren, bei dem Leiterbahnen aus einer Leiterfolie gestanzt werden, wobei der eine Teil der gestanzten Folie auf eine mit einer Maskierung versehene Klebstoff-Bahn gedrückt wird und der andere Teil der gestanzten Folie von einer anderen mit Maskierung versehenen Klebstoff-Bahn abgehoben wird. Dieses Verfahren wird sich vor allem für einfache, sich ergänzende Schaltungsmuster eignen, eher nachteilig sind die Maskierungsvorgänge, da die Maskierung mit dem Leiterbahnmuster genau übereinstimmen muss und das mit möglichst definierter positiver Toleranz, um ein einwandfreies Abheben der gestanzten Leiterbahn zu bewirken. Das bedeutet, dass insbesondere mehrfach gewundene Leiterspiralen eine bestimmte Minimalbreite haben werden.

Bei der Herstellung von Schaltungsanordnungen nach den bekannten Verfahren, bei denen Leiterbahnen auf eine Trägerfolie, beispielsweise durch Heissprägen oder Stanzen, aufgebracht werden, wird der Querschnitt der Trägerfolie wenigstens partiell verändert, sei es, dass eine Reduzierung der Dicke durch das Einstanzen bzw. Einprägen der Leiterbahnen stattfindet oder auch infolge des Aufbringens von zusätzlichen Schichten, wie von Markierungsmitteln beispielsweise, oder dass es zu einem Verwerfen oder Verziehen der Trägerfolie in den den aufgebrachten Leiterbahnen benachbarten Bereichen kommt.

Bei dem erfindungsgemässen Verfahren mit den im kennzeichnenden Teil des Anspruches 1 beschriebenen Merkmalen und bei der erfindungsgemässen Schaltungsanordnung mit den im kennzeichnenden Teil des Anspruches 6 beschriebenen Merkmalen werden alle diese Nachteile vermieden.

Vorteilhafte Weiterbildungen der Erfindung werden in den Merkmalen der abhängigen Ansprüche beschrieben.

Da die gewünschte Leiterbahn aus einer Folie leitenden Materials, sie wird im folgenden als "Metallfolie" bezeichnet, ausgestanzt wird und dieses sogenannte Schaltungspositiv auf die gewünschte Trägerfolie aufgebracht wird, ist jede Art von Substrat möglich, solange dieses nur klebefähig gemacht werden kann. So kann die Trägerfolie auch eine wesentlich. geringere Dicke aufweisen als die darauf aufgebrachte Leiterbahn. Da das das Schaltungsnegativ aufnehmende Stanzuntergrund-Material unwesentlich für das Endprodukt ist, wird daran keine andere Forderung gestellt, als dass es billig und unter dem bestimmten Stanzdruck komprimierbar ist.

Wird der das Einpressen des Schaltungsnegativs in den Stanzuntergrund, das heisst in das Stanzsubstrat, unterstützende Heissiegellack in Rasterform auf den Stanzuntergrund oder auch auf die Metallfolie aufgetragen, so wird das, in Kombination mit dem Einstanzen in den Stanzuntergrund, zum Fixieren des Schaltungsnegativs genügen. Das die gewünschte Leiterbahn darstellende Schaltungspositiv, das ja jeweils an den Rändern auch dem Anpressdruck der Stanze unterworfen ist, wird dann aber nur punktuell unter der Klebewirkung dieses Heissiegellacks stehen. Zur Übertragung dieser Leiterbahn auf eine vorgesehene Trägerfolie muss letztere dann einzig mit einer Klebeschicht versehen sein, deren Haftstärke höher ist als die Haftstärke zwischen Leiterbahn und Stanzuntergrund.

Die Freiheit von Deformations-. und Dickenschwankungen ist relativ zu den Deformations- und Dickenschwankungen bei herkömmlichen Schaltungsanordnungen zu verstehen und in der Regel um eine Grössenordnung geringer als bei diesen.

Die Erfindung ist im folgenden anhand der Zeichnung bespielhaft beschrieben. Es zeigen:

Fig.1 eine erfindungsgemässe Schaltungsanordnung auf einer Trägerfolie;

Fig.1a das Detail I aus Fig.1;

Fig.2 eine schematische Darstellung des Verfahrens zur Herstellung einer der Fig. 1 entsprechenden Schaltungsanordnung;

Fig.2a das Detail II aus Fig.2, und

Fig.3 eine nach dem erfindungsgemässen Verfahren hergestellte Resonanzetikette.

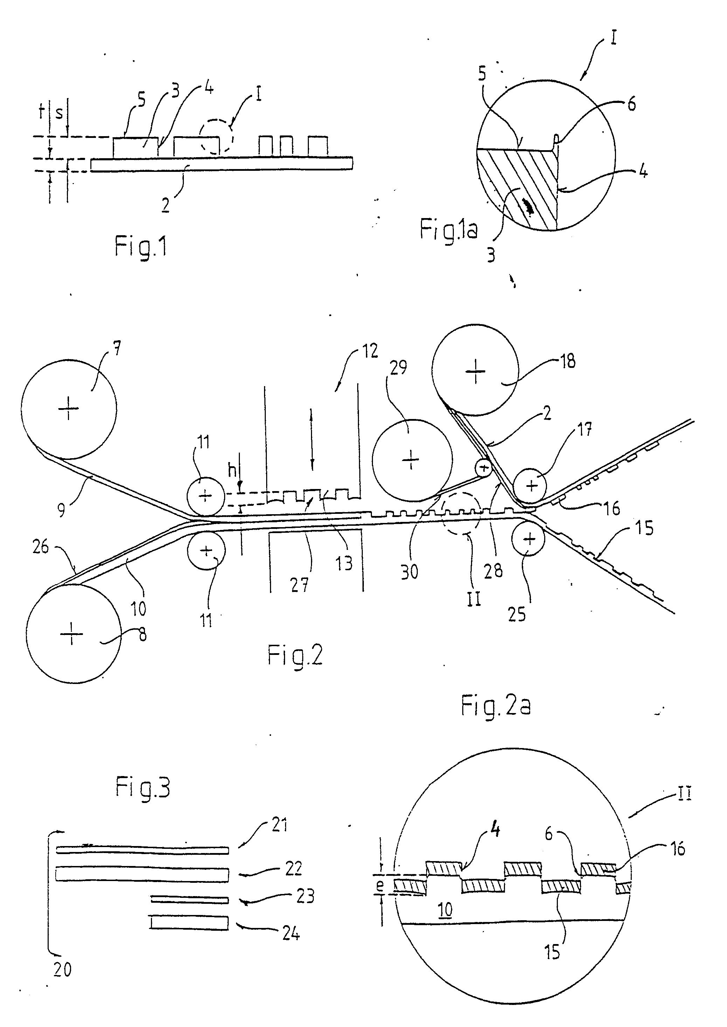

Auf einer Trägerfolie 2 (Fig.1) liegen die in ihrer Gesamtheit die Schaltung darstellenden Leiterbahnen 3. Sie sind aus einer Folie leitenden Materials, im allgemeinen Aluminium oder Kupfer, geschnitten. Die Dicke s dieser Metallfolie und damit die der Leiterbahnen 3, beträgt, beispielsweise für Resonanzetiketten, 50 bis 60 $\mu$m. Die die Leiterbahnen 3 tragende Folie 2, die je nach Verwendungszweck eine z.B. mit Heissiegellack beschichtete Kunststoffolie, eine Klebstoff- oder eine Lackschicht allein sein kann, weist dann eine Dicke t von nur 15 bis 20 $\mu$m auf. Aus Fig.1a ist das Detail I aus Fig.1 zu ersehen, wo die Ausbildung der Leiterbahnen 3 in vergrössertem Massstab dargestellt ist. Da zum Ausschneiden der Leiterbahnen 3 aus der Metallfolie Stanzmesser einer Stanzpresse dienen, wie weiter unten anhand des Verfahrens zur Herstellung einer erfindungsgemässen Schaltungsanordung näher beschrieben wird, ist an der Kante zwischen den Schnitträndern 4 der Leiterbahnen 3 und ihrer Oberfläche 5 ein Vorsprung ausgebildet, der sogenannte Stanzbart 6.

Fig.2 stellt in schematischer Weise das Verfahren zur Herstellung einer erfindungsgemässen Schaltungsanordnung 1 dar. Von Rollen 7 bzw. 8 werden Metallfolie 9 und Stanzsubstrat 10 bandförmig über Lenkrollen 11 in Kontakt miteinander gebracht und durch eine Stanze 12 geführt, wobei die Vorwärtsbewegung schrittweise, dem Arbeitstakt der Stanze 12 und dem Rapport der gewünschten Schaltungsanordnung entsprechend, erfolgt.

Das Stanzsubstrat 10 ist an seiner, der Metallfolie 9 zugekehrten Seite mit einem Heissiegellack 26 beschichtet; es kann aus unterschiedlichstem, sehr kostengünstigem Material bestehen, wie z.B. billigem Packpapier. In gleicher Weise ist die Beschichtung der Metallfolie 9 mit Heissiegellack denkbar (nicht dargestellt). Die Stanzmesser 13 der Stanze 12 werden nun auf Metallfolie 9 und Stanzsubstrat 10 gepresst. Die vorspringenden Stanzmesser 13, die auf eine Temperatur von ca. 120 bis 160° C, gegebenenfalls bis auf 250° C, erwärmt sind, haben einen in etwa konkaven Querschnitt. Die Metallfolie 9 kann an ihrer, den Stanzmessern 13 zugewandten Seite mit Gleitlack beschichtet sein, um auf diese Weise den Schneidevorgang zu begünstigen. Die Metallfolie 9 wird durchschnitten und an den durch die Formgebung der Stanzmesser 13 bestimmten Stellen in das Stanzsubstrat 10 eingepresst. Infolge der Erwärmung wird der Heissiegellack aktiviert; die geschnittenen, in das Stanzsubstrat 10 gepressten Teile der Metallfolie 9 werden dadurch an dem Stanzsubstrat 10 festgeklebt. Die Messerhöhe h, das heisst die lichte Höhe der von den Stanzmessern 13 gebildeten Zwischenräume 27, ist dabei so zu wählen, dass sie grösser als ein durch die Summe aus der Dicke s der Metallfolie 9 und der durch die Komprimierbarkeit des Stanzsubstrats 10 bestimmten Einpresstiefe e (Fig.2a) definierter Wert ist. Nur dann ist gewährleistet, dass die zwischen den geschnittenen, eingepressten, das Schaltungsnegativ bildenden Metallfolienteilen 15 liegenden Teile 16, die das Schaltungspositiv und damit schliesslich die Leiterbahnen 3 darstellen, von den Metallfolienteilen 15 einwandfrei getrennt werden und nicht am Stanzsubstrat 10 festkleben. Einzig an den Schnitträndern 4 wird das Schaltungspositiv 16 einem gewissen Anpressdruck ausgesetzt sein und so auch erwärmt werden. Damit wird es nur in diesen Randbereichen am mit Heissiegellack beschichteten Stanzsubstrat 10 haften, hingegen in den anderen Bereichen nur leicht aufliegen. Wird der Heissiegellack jedoch beispielsweise rasterförmig auf das Stanzsubstrat 10 bzw. auf die Metallfolie 9 aufgetragen, so wird das Schaltungspositiv 16 nur punktuell am Stanzsubstrat 10 haften, was genügt, um es für die weiteren Verfahrensschritte am Stanzsubstrat 10 festzuhalten. Gleichzeitig wird der Transferierungsvorgang vereinfacht.

Auch aus Fig.2a ist der beim Stanzvorgang entstehende Stanzbart 6 zu ersehen.

Auf das Stanzsubstrat 10 mit den darauf fest eingepressten Teilen 15 der Metallfolie und dem daraufliegenden Schaltungspositiv 16 wird über Führungsrollen 17 und 25 die über eine Rolle 18 bereitgestellte Trägerfolie 2 aufgedrückt. In Fig.2 ist das das Schaltungspositiv 16 tragende Stanzsubstrat 10 mit dem darauf eingepressten Schaltungsnegativ 15 nur schematisch dargestellt. Fig.2a zeigt deshalb ein vergrössertes Detail dieser Anordnung. Diese Trägerfolie 2 ist mit einer Klebstoff-Schicht 28 beschichtet, wobei es sich beispielsweise um einen durch Druck aktivierbaren Klebstoff handeln kann. Falls Heissiegellack zur Anwendung kommt, ist die die Trägerfolie 2 führende Rolle 17 vorzugsweise beheizt und aktiviert den Klebstoff. Dadurch wird das relativ schwach (weil nur in bestimmten Randbereichen) am Stanzsubstrat 10 haftende Schaltungspositiv 16 von diesem abgehoben und auf die Trägerfolie 2a transferiert. Bedingung dafür ist, dass die Haftkraft des Klebers, mit dem die Trägerfolie 2 beschichtet ist, grösser ist als die des Klebers, mit dem das Stanzsubstrat 10 bzw. die Metallfolie 9 beschichtet ist. Da die das Schaltungsnegativ darstellenden Metallfolienteile 15 in das Stanzsubstrat 10 vertieft eingepresst sind, können sie bei diesem Vorgang nicht auf die Trägerfolie 2 mittransferiert werden. Das Stanzsubstrat 10 mit dem eingepressten Schaltungsnegativ 15 kann über eine Rolle einer Einrichtung zur Wiedergewinnung der eingepressten Metallfolienteile zugeführt werden.

Ist die Trägerfolie 2 selbstklebend, so kann sie auf der Rolle 18 vorteilhafterweise mit Release-Papier 30 belegt aufgebracht sein, welches dann beim Abrollen der Trägerfolie 2 über eine Rolle 29 entfernt wird.

Die das Schaltungspositiv 16 aufnehmende Trägerfolie 2 kann also völlig frei gewählt werden, was sowohl ihre Dicke als auch ihr Material betrifft, solange die Trägerfolie 2 nur klebefähig gemacht werden kann. Sie bleibt bei dem Transferierungsvorgang im wesentlichen plan, sie wird dabei so gut wie nicht, nicht einmal partiell, gepresst, geknickt, verzogen oder verworfen.

Anstelle des oben beschriebenen Stanzvorgangs kann in analoger Weise ein Prägevorgang vorgesehen sein. Vorzugsweise heizbare Prägestempel stellen dann anstelle der Stanzmesser das Klischee für die Leiterbahnen dar. Stanzmesser bzw. Prägestempel können vorzugsweise auch auf Zylindern angeordnet sein; Stanz- bzw. Prägevorgang sind dann rotativ.

Fig.3 zeigt schematisch die einzelnen Schichten, aus denen eine nach dem erfindungsgemässen Verfahren hergestellte Resonanzetikette 20 zusammengesetzt ist. Dazu ist wenigstens eine Induktionsspule und wenigstens eine Kondensatorplatte in einer Schicht 22 und wenigstens eine zweite Kondensatorplatte in einer Schicht 24 vorzusehen, wobei zwischen diesen beiden leitenden Schichten 22 und 24 eine Dielektrikumsschicht 23 liegt. Induktionsspule und Kondensator definieren miteinander den Schwingkreis. Die spezielle Ausformung, die durch die Formgebung des Stanzwerkzeugs bzw. der Stanzmesser geschieht, bestimmt - gemeinsam mit der Dielektrikumsschicht 23 - die elektrischen Eigenschaften der Resonanzetikette 20. Die Schicht 21 ist beispielsweise bedruckbares Papier, womit beliebige Etiketten versehen werden. Die Dielektrikumsschicht 23 sollte schon aus Deaktivierungsgründen denkbar dünn ausgebildet sein, um die zur sicheren Deaktivierung nötige Energie möglichst niedrig halten zu können. Wird daher eine Resonanzetikette 20 entsprechend dem erfindungsgemässen Verfahren hergestellt, so können eine oder auch beide leitende Schichten 22, 24 in der oben beschriebenen Weise auf die Dielektrikumsschicht 23 transferiert werden, wobei diese Dielektrikumsschicht 23 dann vorzugsweise als Klebe- oder Lackschicht, beispielsweise beidseitig mit Release-Papier belegt und auf einer Rolle bereitgestellt, ausgeformt sein kann, die nacheinander an ihren beiden Seiten die jeweiligen Leiterbahnen von entsprechend geprägten Stanzsubstraten abhebt.

In analoger Weise kann aber auch eine zur Abdeckung bzw. zur Beschriftung der Resonanzetikette 20 vorgesehene Schicht 21 als Trägerfolie, die beispielsweise Papier oder Kunststoff sein kann, für eine leitende Schicht 22 bzw. 24 dienen. Der Aufbau der Resonanzetikette 20 entspricht dann dem zweier miteinander verbundener erfindungsgemässer Schaltungsanordnungen.

**Ansprüche**

1. Verfahren zur Herstellung einer Schaltungsanordnung - insbesondere von einer Vielzahl von Schaltungsanordnungen -, die aus einer, vorzugsweise bahnförmigen, leitenden Folie (9) ausgestanzt und mittels einer Klebstoffschicht (28) auf eine Trägerfolie (2) aufgebracht wird, dadurch gekennzeichnet, dass ein Schaltungsnegativ (15) aus einer leitenden Folie (9) mittels ein Klischee darstellender Stanzmesser (13) oder Prägestempel in ein Stanzsubstrat (10) eingeprägt und die das verbleibende Schaltungspositiv (16) darstellende Leiterbahn (3) auf die Trägerfolie (2) transferiert wird.

2. Verfahren nach Anspruch 1, dadurch gekennzeichnet, dass das Stanzsubstrat (10) und/oder die leitende Folie (9) mit einem Klebstoff (26) vorzugsweise mit einem - gegebenenfalls rasterförmig aufgebrachten - Heissiegellack beschichtet ist.

3. Verfahren nach Anspruch 2, dadurch gekennzeichnet, dass die Trägerfolie (2) mit einem derartigen Klebstoffschicht (28), vorzugsweise aus Heissiegellack, belegt ist oder selbst aus einer derartigen Klebstoffschicht besteht, dass die von der Trägerfolie (2) über die Klebstoffschicht (28) auf das Schaltungspositiv (16) ausgeübte Haftkraft grösser ist als die auf das Stanzsubstrat (10) und das Schaltungspositiv (16) ausgeübte Haftkraft des Klebstoffs (26).

4. Verfahren nach einem der Ansprüche 1 bis 3, dadurch gekennzeichnet, dass die Prägestempel oder die - vorzugsweise einen konkaven Querschnitt aufweisenden - Stanzmesser (13) erwärmbar sind und Zwischenräume (27) begrenzen, deren lichte Höhe (h) grösser ist als die Summe aus der Dicke (s) der leitenden Folie (9) und der Einpresstiefe (e) der Prägestempel oder Stanzmesser (13) in das Stanzsubstrat (10).

5. Verfahren nach einem der Ansprüche 1 bis 4, dadurch gekennzeichnet, dass das Schaltungspositiv (16) über wenigstens eine, insbesondere heizbare, Führungsrolle (17) mit der Trägerfolie (2) zusammengeführt und auf die Trägerfolie (2) transferiert wird.

6. Schaltungsanordnung, bei der wenigstens eine elektrische Leiterbahn (3) geschnitten auf wenigstens einer Oberfläche einer Trägerfolie (2) mittels einer Klebstoffschicht (28) angeordnet ist, dadurch gekennzeichnet, dass die Oberfläche der Klebstoffschicht (28) neben jedem Teil der Leiterbahn (3) frei von anderen Materialien ist, wobei die Trägerfolie (2) sowohl im Bereich der sie bedeckenden Leiterbahn (3) als auch ausserhalb davon im wesentlichen frei von Deformationen und Schwankungen der Dicke (t) ist und gegebenenfalls selbst aus dieser Klebstoffschicht (28) besteht.

7. Schaltungsanordnung nach Anspruch 6, dadurch gekennzeichnet, dass die Leiterbahn (3) an den zwischen ihrer Oberfläche (5) und ihren geschnittenen Seitenflächen (4) gebildeten Kanten einen Vorsprung in Form eines Stanzbartes (6) aufweist.

8. Schaltungsanordnung nach Anspruch 6 oder 7, dadurch gekennzeichnet, dass die Dicke (t) der Trägerfolie (2) wenigstens um 10% geringer ist als die Dicke (s) der aufliegenden Leiterbahn (3), wobei die Dicke (s) der Leiterbahn (3) vorzugsweise 20 bis 70 μm, insbesondere 40 bis 60 μm, die entsprechende Dicke (t) der Trägerfolie (2) vorzugsweise 5 bis 60 μm, insbesondere 5 bis 40 μm, beträgt.

9. Schaltungsanordnung nach einem der Ansprüche 6 bis 8, für eine Resonanzetikette (20), dadurch gekennzeichnet, dass die Leiterbahn (3) in Form wenigstens einer Induktionsspule und/oder wenigstens einer Kondensatorplatte auf der Trägerfolie (2) aufliegend ausgebildet ist, wobei die Trägerfolie (2) als Dielektrikums-Schicht (23) und/oder als abdeckende Schicht (21) ausgebildet ist.

10. Schaltungsanordnung nach Anspruch 9, dadurch gekennzeichnet, dass die als Dielektrikums-Schicht (23) dienende Trägerfolie (2) als Kunststoff-Schicht oder als Klebstoff-Schicht, gegebenenfalls als Lack-Schicht, ausgebildet ist.

Fig.1

Fig.1a

Fig.2

Fig.2a

Fig.3

Europäisches
Patentamt

**EUROPÄISCHER
RECHERCHENBERICHT**

Nummer der Anmeldung

**EP 90 11 9630**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A,X | EP-A-0 292 827  (DURGO AG)<br>* Spalte 4, Zeile 11 - Spalte 6, Zeile 41 * * Spalte 7, Zeilen 10 - 22; Figuren 1, 2, 4-7 *<br>— — — | 1-3,5,6, 8-10 | H 05 K 3/20<br>H 05 K 3/04<br>G 08 B 13/24 |
| A | US-A-2 969 300  (FRANZ)<br>* Spalte 3, Zeile 41 - Spalte 4, Zeile 69; Figuren 1-3 *<br>— — — | 1-3,5,6 | |
| A | US-A-3 301 730  (SPIWAK ET. AL.)<br>* Spalte 3, Zeile 19 - Spalte 4, Zeile 21; Figuren 1-7 *<br>— — — | 1,2,4,6,8 | |
| D,A | EP-A-0 063 347  (IVO IRION & VOSSELER ZAHLERFA-BRIK)<br>* Seite 5, Zeile 30 - Seite 7, Zeile 26; Figuren 1, 2 *<br>— — — | 1,2,4,6,8 | |
| D,A | US-A-3 678 577  (WEGLIN ET. AL.)<br>* Ansprüche ; Figuren 6, 7 *<br>— — — | 1,2,4,6 | |
| D,A | DE-A-3 732 825  (MONARCH MARKING SYSTEMS)<br>— — — — — | | |

| | RECHERCHIERTE SACHGEBIETE (Int. Cl.5) |
|---|---|
| | H 05 K<br>G 08 B<br>H<br>01 F<br>H 01 L |

Der vorliegende Recherchenbericht wurde für alle Patentansprüche erstellt

| Recherchenort | Abschlußdatum der Recherche | Prüfer |
|---|---|---|
| Den Haag | 28 Januar 91 | MES L.A. |